# EUROPÄISCHE PATENTSCHRIFT

(11) **EP 3 124 988 B1**
(45) Veröffentlichungstag und Bekanntmachung des Hinweises auf die Patenterteilung: **20.02.2019**
(21) Anmeldenummer: 16181223.5
(22) Anmeldetag: 26.07.2016
(51) Int. Cl.: G01R 31/44, G01R 31/26, G01R 19/165, G01R 31/02, H05B 33/08, G08G 1/097, G08G 1/095

(54) **LEUCHTDIODEN-STEUERUNGSSCHALTUNG FÜR EINEN SIGNALGEBER EINER LICHTSIGNALANLAGE**
LIGHT EMITTING DIODE CONTROL CIRCUIT FOR A SIGNAL GENERATOR OF AN ILLUMINATING SIGNAL SYSTEM
CIRCUIT DE COMMANDE DE DIODES ELECTROLUMINESCENTES POUR UN EMETTEUR DE SIGNAL D'UNE INSTALLATION DE SIGNAL LUMINEUX

(30) Priorität: 31.07.2015 DE 102015214597
(43) Veröffentlichungstag der Anmeldung: 01.02.2017
(73) Patentinhaber: Siemens Mobility GmbH, 81739 München (DE)
(72) Erfinder: Junker, Heiko, 85570 Markt Schwaben (DE)

(56) Entgegenhaltungen:
- WO-A1-86/01904
- US-A1- 2003 160 703

## Beschreibung

Die Erfindung betrifft eine Leuchtdioden-Steuerungsschaltung für eine Leuchtdiodenanordnung eines Signalgebers einer Lichtsignalanlage. Außerdem betrifft die Erfindung eine Verwendung einer Leuchtdioden-Steuerungsschaltung.

Lichtsignalanlagen werden zur Regelung von Verkehrssituationen verwendet, insbesondere im Straßenverkehr. Sie ordnen für Verkehrsteilnehmer ein bestimmtes Verhalten an, indem gesteuerte Lichtsignale abgegeben werden. Diese nach Form und Farbe verschiedenartigen Verkehrszeichen haben jeweils eine andere Bedeutung und strahlen nur entgegen der Fahrtrichtung des zu regelnden Verkehrs ab. Der Einsatz von Lichtsignalanlagen hat unterschiedliche Gründe, beispielsweise um den Verkehrsfluss zu verbessern und gefährliche oder gefahrenträchtige Verkehrssituationen zu entschärfen. Im Straßenverkehr sind dies insbesondere Einmündungen sowie Engstellen, zum Beispiel bei Baustellen oder Brücken.

Heutzutage werden für die Signalgebung Leuchtdioden (kurz LED genannt) verwendet. Diese verbrauchen deutlich weniger Energie als herkömmliche Leuchtmittel. LED-Signalgeber haben eine Überwachungseinrichtung, mit der defekte LEDs detektiert werden können und im Fall eines Defekts einer LED eine Zwangsabschaltung des LED-Signalgebers veranlasst werden kann. Eine solche Überwachungsschaltung misst die elektrische Spannung, welche zwischen dem Eingang und dem Ausgang einer LED anliegt. Wird ein Spannungswert gemessen, der außerhalb eines definierten Bereichs liegt, so wird daraus geschlossen, dass die LED defekt ist, und der LED-Signalgeber wird dauerhaft abgeschaltet. Das Abschalten einer LED kann zum Beispiel durch das Durchbrennen einer Sicherung erreicht werden. Eine Überspannung an der LED kann beispielsweise gemessen werden, wenn aufgrund eines Bruchs in der LED kein Strom fließt. Eine Unterspannung an der LED kann zum Beispiel dann gemessen werden, wenn innerhalb der LED ein Kurzschluss auftritt. Herkömmlich werden solche Spannungswerte mit Hilfe einer Basis-Emitter-Schaltung mit einem bipolaren Transistor gemessen. Wird ein Spannungswert gemessen, der einen Defekt der Leuchtdiode vermuten lässt, so erfolgt eine Zwangsabschaltung des Signalgebers, so dass der Signalgeber dauerhaft außer Betrieb genommen wird und eine Falschanzeige und Irreführung des Verkehrs vermieden wird.

Bisher wurde nur die elektrische Spannung an den Leuchtdioden von Signalgebern gemessen. Wurden Spannungswerte gemessen, die außerhalb eines definierten Bereichs lagen, so wurde dies als Ausfall interpretiert und der Signalgeber wurde mit Hilfe einer Sicherungsschaltung, bei der ein Sicherungswiderstand im Schadensfall zum Durchbrennen gebracht wurde, abgeschaltet.

Es sind jedoch auch Fälle denkbar, in denen trotz defekter Leuchtdiode bzw. defekter oder falscher Ansteuerung noch eine elektrische Spannung über der Leuchtdiode gemessen wird, die noch innerhalb des definierten Bereichs liegen. Beispielsweise gibt es ein Ansteuerungsverfahren, bei dem die LED durch kurze Stromimpulse angesteuert wird. Da die Spannungsmessung und die darauf aufbauende Abschaltung im Fehlerfall auf Grund anderer zeitlicher Anforderungen etwas träger dimensioniert sind, wird die Zwangsabschaltung trotz dunkler LED nicht in jedem Fall aktiviert.

Somit kann es trotz Spannungsüberwachung dazu kommen, dass eine Leuchtdiode defekt ist und eine Zwangsabschaltung bei einer herkömmlichen Signalgeberschaltung entweder gar nicht oder zu spät erfolgt.

In US 2003/ 0 160 703 A1 wird eine Überwachungsschaltung zur Fehlerdiagnose von Leuchtdiodeneinheiten beschrieben. Dabei erfolgt eine Stromüberwachung mit Hilfe zweier Komparatoren, welche parallel zueinander geschaltet sind.

In WO 86/ 01904 A1 wird eine Schaltung zur Überwachung eines Lüfters beschrieben, welche eine Stromüberwachung mit einer Spannungsüberwachung kombiniert.

Es ist mithin eine Aufgabe der vorliegenden Erfindung, eine vereinfachte Leuchtdioden-Steuerungsschaltung zur Überwachung einer Leuchtdiodenanordnung eines Signalgebers einer Lichtsignalanlage zu entwickeln, welche die Funktionsfähigkeit der Leuchtdiodenanordnung mit erhöhter Zuverlässigkeit überwacht.

Diese Aufgabe wird durch eine Leuchtdioden-Steuerungsschaltung für eine Leuchtdiodenanordnung eines Signalgebers einer Lichtsignalanlage gemäß Patentanspruch 1, durch einen Signalgeber gemäß Patentanspruch 11, durch die Verwendung einer Leuchtdioden-Steuerungsschaltung gemäß Patentanspruch 12.

Die erfindungsgemäße Leuchtdioden-Steuerungsschaltung für eine Leuchtdiodenanordnung eines Signalgebers einer Lichtsignalanlage umfasst eine Stromüberwachungsschaltung, welche eine Referenzspannungsquelle mit einem Eingang, einem ersten Ausgang und einem zweiten Ausgang aufweist. An dem Eingang der Referenzspannungsquelle kann zum Beispiel eine Versorgungsspannung anliegen. Als Leuchtdiodenanordnung soll in diesem Zusammenhang eine Schaltungsanordnung mit mindestens einer Leuchtdiode verstanden werden. Die Leuchtdiodenanordnung kann aber auch mehrere Leuchtdioden aufweisen, die vorzugsweise in Reihe geschaltet sind. Besonders bevorzugt umfasst eine solche Leuchtdiodenanordnung ein bis drei Leuchtdioden, welche zueinander in Reihe geschaltet sind. Im Folgenden wird auch oft einfach von "Leuchtdiode" gesprochen. Diese Bezeichnung soll die genannten Varianten mit einer oder mehreren Leuchtdioden umfassen. Wird zum Beispiel von einer Messung einer an einer Leuchtdiode abfallenden elektrischen Spannung gesprochen, so soll damit auch eine Messung einer elektrischen Spannung umfasst sein, welche an mehreren, in Reihe geschalteten Leuchtdioden abfällt.

Die Stromüberwachungsschaltung weist außerdem eine erste Komparatorschaltung mit einem ersten Eingang, einem zweiten Eingang und einem Signalausgang auf. Teil der Stromüberwachungsschaltung ist auch ein Messwiderstand, der zu der Leuchtdiodenanordnung in Serie geschaltet ist. Der erste Ausgang der Referenzspannungsquelle der Stromüberwachungsschaltung weist ein durch die Referenzspannungsquelle definiertes Referenzpotential auf und ist mit dem ersten Eingang der ersten Komparatorschaltung elektrisch verbunden. Das Referenzpotential an dem ersten Ausgang der Referenzspannungsquelle wird als Vergleichsgröße genutzt, um mit Hilfe der ersten Komparatorschaltung zu ermitteln, ob eine Leuchtdiode korrekt funktioniert, d.h., ob ein Strom durch die LED fließt. Für diese Ermittlung wird eine an dem Messwiderstand abfallende, durch den Stromfluss bedingte elektrische Spannung gemessen. Der Messwiderstand ist dazu zwischen den zweiten Ausgang der Referenzspannungsquelle und den zweiten Eingang der ersten Komparatorschaltung geschaltet. Beispielsweise kann ein Vergleich der gemessenen elektrischen Spannung und des Referenzpotentials dahingehend durchgeführt werden, dass ermittelt wird, ob der gemessene elektrische Spannungswert den Wert des Referenzpotentials unterschreitet. Falls das der Fall ist, wird von der ersten Komparatorschaltung ein logisches Signal ausgegeben, das mit einem fehlenden Strom durch die Leuchtdiode assoziiert ist. Gründe hierfür können sowohl ein Defekt der Leuchtdiode als auch der LED-Ansteuerschaltung sein. Statt einem Komparator können auch mehrere Komparatoren als Vergleichsoperatoren verwendet werden, wenn zum Beispiel ermittelt werden soll, ob der Messwert in einem vorgegebenen Intervall liegt.

Teil der erfindungsgemäßen Leuchtdioden-Steuerungsschaltung ist auch eine Leuchtdiodenschnittstelle. Die Leuchtdiodenschnittstelle dient als elektrische Verbindung zwischen der Stromüberwachungsschaltung und der Leuchtdiodenanordnung. Darüber hinaus umfasst die erfindungsgemäße Leuchtdioden-Steuerungsschaltung eine Sicherungsschaltung, welche mit dem Signalausgang der Stromüberwachungsschaltung, d.h. dem Signalausgang des ersten Komparators elektrisch verbunden ist. Die Sicherungsschaltung ist durch ein Ausschaltsignal an dem Signalausgang der Stromüberwachungsschaltung in einen Ausschaltzustand versetzbar.

Zudem weist die erfindungsgemäße Leuchtdioden-Steuerungsschaltung zusätzlich zu der Stromüberwachungsschaltung eine Spannungsüberwachungsschaltung zur Überwachung der an einer Leuchtdiodenanordnung abfallenden elektrischen Spannung auf. Zur Auswertung der von der Stromüberwachungsschaltung und der Spannungsüberwachungsschaltung ermittelten Vergleichsergebnisse umfasst die erfindungsgemäße Leuchtdioden-Steuerungsschaltung eine zweite Komparatorschaltung. Die zweite Komparatorschaltung weist einen ersten nicht-invertierenden Eingang, einen zweiten invertierenden Eingang und einen Ausgang auf. Der erste Eingang der zweiten Komparatorschaltung ist mit einem dritten Ausgang der Referenzspannungsquelle elektrisch verbunden. Dabei kann die an dem dritten Ausgang der Referenzspannungsquelle anliegende elektrische Referenzspannung von der ersten elektrischen Referenzspannung deutlich abweichen. Der zweite Eingang der zweiten Komparatorschaltung ist mit einem Ausgang der Spannungsüberwachungsschaltung und dem Signalausgang der Stromüberwachungsschaltung elektrisch verbunden. Die Ausgangssignale der Spannungsüberwachungsschaltung und der Stromüberwachungsschaltung können zum Beispiel logische Signale sein, deren Pegel zwei verschiedene Werte annehmen kann, die gewöhnlich als H-Signal und als L-Signal bezeichnet werden. Entsprechend wird auch für die zweite Referenzspannung ein Spannungswert gewählt, welcher zwischen den beiden möglichen Spannungspegeln der logischen Signale liegt. Mit dieser Anordnung werden gleich mehrere Kenngrößen, in diesem Fall die Stromstärke und die elektrische Spannung, einer Leuchtdiodenanordnung überwacht. Eine Überwachung mehrerer Kenngrößen erlaubt eine zuverlässigere Überwachung der Funktionsfähigkeit von solchen Leuchtdiodenanordnungen. Bei dem oben beschriebenen Fall, bei dem die LED durch kurze Stromimpulse angesteuert wird, kann die Stromüberwachung z.B. mit einer anderen zeitlichen Trägheit (z.B. schneller) dimensioniert werden als die Spannungsmessung, so dass auch bei gepulster Ansteuerung ein Defekt einer Leuchtdiode oder deren Steuerungsschaltung erkannt wird.

Der erfindungsgemäße Signalgeber für eine Lichtsignalanlage weist eine Leuchtdiodenanordnung auf. Zudem umfasst der erfindungsgemäße Signalgeber auch eine erfindungsgemäße Leuchtdioden-Steuerungsschaltung.

Die erfindungsgemäße Leuchtdioden-Steuerungsschaltung wird erfindungsgemäß zur Überwachung der Funktion einer Leuchtdiodenanordnung eines Signalgebers einer Lichtsignalanlage verwendet. Insbesondere wird mit Hilfe der erfindungsgemäßen Schaltung ermittelt, ob eine Leuchtdiode oder eine Leuchtdiodenanordnung einen Kurzschluss oder eine Unterbrechung des elektrischen Strom leitenden Bereichs aufweist. Wird eine Funktionsstörung ermittelt, so erfolgt vorzugsweise automatisiert eine Abschaltung der betroffenen Leuchtdiodenanordnung.

Dabei wird zur Überwachung der Funktion einer Leuchtdiodenanordnung eines Signalgebers einer Lichtsignalanlage ein durch eine Leuchtdiodenanordnung fließender elektrischer Strom durch Messen einer an einem mit der Leuchtdiodenanordnung in Serie geschalteten Messwiderstand abfallenden elektrischen Spannung erfasst. Es wird die gemessene elektrische Spannung mit einer Referenzspannung verglichen und ein Ausschaltsignal für den Fall ausgegeben, dass bei dem Vergleich eine Abweichung des gemessenen elektrischen Spannungswerts von der Referenzspannung einen vorbestimmten Maximalwert überschritten hat.

Die abhängigen Ansprüche sowie die nachfolgende Beschreibung enthalten jeweils besonders vorteilhafte Ausgestaltungen und Weiterbildungen der Erfindung. Dabei können insbesondere die Ansprüche einer Anspruchskategorie auch analog zu den abhängigen Ansprüchen einer anderen Anspruchskategorie weitergebildet sein. Zudem können im Rahmen der Erfindung auch die verschiedenen Merkmale unterschiedlicher Ausführungsbeispiele und Ansprüche auch zu neuen Ausführungsbeispielen kombiniert werden.

In einer bevorzugten Ausgestaltung der erfindungsgemäßen Leuchtdioden-Steuerungsschaltung ist der zweite Ausgang der Referenzspannungsquelle mit einem festen zweiten Referenzpotential elektrisch verbunden. Vorzugsweise handelt es sich bei dem festen zweiten Referenzpotential um ein Massepotential oder Erdpotential.

In einer alternativen Ausgestaltung der erfindungsgemäßen Leuchtdioden-Steuerungsschaltung weist die Spannungsüberwachungsschaltung eine dritte Komparatorschaltung mit einem ersten Eingang, einem zweiten Eingang und einem Signalausgang auf. Die dritte Komparatorschaltung dient der Überwachung der an der Leuchtdiodenanordnung abfallenden elektrischen Spannung. Mit der dritten Komparatorschaltung kann zum Beispiel ermittelt werden, ob eine an der betreffenden Leuchtdiodenanordnung abfallende elektrische Spannung einen vorbestimmten Schwellwert überschreitet oder nicht. Für diese Vergleichsoperation ist der erste Eingang der dritten Komparatorschaltung mit einem vierten Ausgang der Referenzspannungsquelle elektrisch verbunden, an dem ein durch die Referenzspannungsquelle definiertes viertes Referenzpotential anliegt. Der zweite Eingang der dritten Komparatorschaltung ist mit einem Anschluss der Leuchtdiodenanordnung des Signalgebers elektrisch verbunden.

Bevorzugt weist die erfindungsgemäße Leuchtdioden-Steuerungsschaltung einen ersten Spannungsteiler auf, welcher parallel zu der Leuchtdiodenanordnung geschaltet ist und einen ersten ohmschen Widerstand und einen zweiten ohmschen Widerstand aufweist, welche zueinander in Reihe geschaltet sind. Der zweite Eingang der dritten Komparatorschaltung ist zwischen den ersten ohmschen Widerstand und den zweiten ohmschen Widerstand geschaltet.

In einer bevorzugten Variante weist die erfindungsgemäße Leuchtdioden-Steuerungsschaltung eine vierte Komparatorschaltung mit einem ersten Eingang, einem zweiten Eingang und einem Signalausgang auf. Der erste Eingang der vierten Komparatorschaltung ist mit dem ersten Eingang der dritten Komparatorschaltung parallel geschaltet, d.h., der erste Eingang der vierten Komparatorschaltung ist ebenfalls mit dem vierten Ausgang der Referenzspannungsquelle elektrisch verbunden und der zweite Eingang der vierten Komparatorschaltung ist mit dem ersten Anschluss der Leuchtdiodenanordnung elektrisch verbunden. Mit Hilfe der dritten und vierten Komparatorschaltung lässt sich die elektrische Spannung an der Leuchtdiodenanordnung dahingehend überwachen, dass ermittelt wird, ob der Wert der an der Leuchtdiodenanordnung abfallenden elektrischen Spannung in einem vorbestimmten Wertebereich liegt oder nicht.

In einer besonders effektiven Variante der erfindungsgemäßen Leuchtdioden-Steuerungsschaltung ist der erste Eingang der dritten Komparatorschaltung ein nicht-invertierender Eingang, ist der zweite Eingang der dritten Komparatorschaltung ein invertierender Eingang, ist der erste Eingang der vierten Komparatorschaltung ein invertierender Eingang und ist der zweite Eingang der vierten Komparatorschaltung ein nicht-invertierender Eingang.

In einer besonders bevorzugten Ausgestaltung weist die erfindungsgemäße Leuchtdioden-Steuerungsschaltung einen zweiten Spannungsteiler auf, welcher parallel zu dem ersten Spannungsteiler geschaltet ist und einen dritten ohmschen Widerstand und einen vierten ohmschen Widerstand umfasst, welche zueinander in Serie geschaltet sind. Der zweite Eingang der vierten Komparatorschaltung ist zwischen den dritten ohmschen Widerstand und den vierten ohmschen Widerstand des zweiten Spannungsteilers geschaltet.

In einer besonders effektiven Ausgestaltung der erfindungsgemäßen Leuchtdioden-Steuerungsschaltung sind die Ausgänge der dritten und vierten Komparatorschaltung der Spannungsüberwachungsschaltung mit dem zweiten Ausgang der zweiten Komparatorschaltung elektrisch verbunden. Die Ausgangssignale der Komparatorschaltungen der Spannungsüberwachungsschaltung können ohne zusätzlichen Einsatz eines logischen Bauelements auf dieselbe Signalleitung geschaltet werden, welche mit dem zweiten Eingang der als Negatorschaltung funktionierenden zweiten Komparatorschaltung elektrisch verbunden ist. Mit dem zweiten Eingang der zweiten Komparatorschaltung ist auch der Ausgang der Komparatorschaltung der Stromüberwachungsschaltung elektrisch verbunden, so dass die Ausgangssignale der Stromüberwachungsschaltung und der Spannungsüberwachungsschaltung an derselben Signalleitung anliegen, welche mit dem zweiten Eingang der zweiten Komparatorschaltung elektrisch verbunden ist.

Die Ausgänge der ersten, dritten und vierten Komparatorschaltung sind vorzugsweise als offene Kollektor-Ausgänge ausgebildet. Die Ausbildung der Ausgänge der Komparatoren als offene Kollektorausgänge hat den Vorteil, dass die Ausgänge der genannten Komparatoren auf eine gemeinsame Signalleitung geschaltet werden können, ohne dass sich bei unterschiedlichem Ausgangspegel ein Kurzschlussstrom ausbildet, der die Schaltelemente der Komparatoren beschädigen könnte. Somit können die Ausgänge der genannten Komparatoren zueinander parallel geschaltet werden und ein andernfalls zur Absicherung der Schaltung eventuell notwendiges zusätzliches ODER-Gatter kann eingespart werden.

In einer besonders bevorzugten Variante der erfindungsgemäßen Leuchtdioden-Steuerungsschaltung sind die Ausgänge der ersten, dritten und vierten Komparatorschaltung mit einem Pull-up-Widerstand elektrisch verbunden. Mit Hilfe des Pull-des-Widerstands lässt sich ein Signal mit einem hohen Pegel am Ausgang einer der Komparatorschaltungen auf einen definierten Pegel setzen, der durch eine feste, an dem Pull-up-Widerstand anliegende elektrische Spannung definiert wird.

Wie bereits erwähnt, kann die erfindungsgemäße Leuchtdioden-Steuerungsschaltung zusätzlich zu der Stromüberwachungsschaltung auch eine Spannungsüberwachungsschaltung zur Überwachung der an der Leuchtdiodenanordnung abfallenden elektrischen Spannung umfassen. Durch die Implementierung der beiden unterschiedlichen Überwachungspfade lässt sich eine teilweise redundante, zuverlässige Überwachung der Leuchtdiodenanordnung realisieren.

In einer speziellen Variante der erfindungsgemäßen Leuchtdioden-Steuerungsschaltung umfasst die Sicherungsschaltung einen Transistor, vorzugsweise einen Feldeffekttransistor, und einen mit dem Transistor in Reihe geschalteten Sicherungswiderstand. Dabei ist vorzugsweise das Gatter des Transistors mit dem Ausgang der Stromüberwachungsschaltung und damit der zweiten Komparatorschaltung elektrisch verbunden.

Der Einsatz eines Feldeffekttransistors als Schalttransistor hat den Vorteil im Vergleich zum Einsatz eines Bipolartransistors, dass ein Feldeffekttransistor einen relativ geringen Source-Drain-Widerstand im Vergleich zu einem Kollektor-Emitter-Widerstand eines Bipolartransistors aufweist. Somit kann ein Feldeffekttransistor deutlich kleiner dimensioniert werden, was platzsparend und kostengünstig ist.

Die Erfindung wird im Folgenden unter Hinweis auf die beigefügten Figuren anhand von Ausführungsbeispielen noch einmal näher erläutert. Es zeigen:
- FIG 1: ein Schaltbild einer Schaltungsanordnung mit einer Stromüberwachungsschaltung gemäß einem Ausführungsbeispiel der Erfindung,
- FIG 2: ein Schaltbild einer Schaltungsanordnung mit einer Strom-Spannungsüberwachungsschaltung gemäß einem alternativen Ausführungsbeispiel der Erfindung,
- FIG 3: ein Flussdiagramm, welches ein Verfahren zur Stromüberwachung einer Leuchtdiode eines Signalgebers einer Lichtsignalanlage gemäß einem Ausführungsbeispiel der Erfindung veranschaulicht.

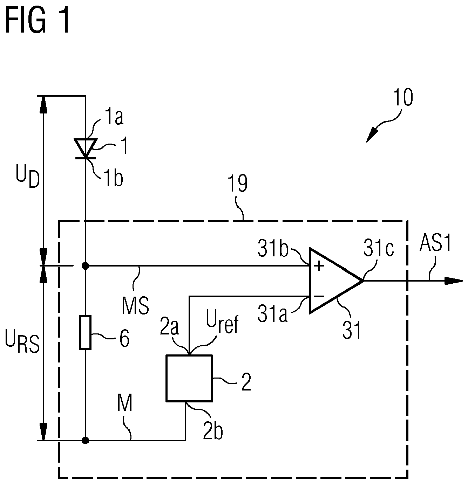

In FIG 1 ist ein Schaltbild einer Schaltungsanordnung 10 eines Signalgebers mit einer Stromüberwachungsschaltung 19 gemäß einem Ausführungsbeispiel der Erfindung und einer Leuchtdiode 1 gezeigt. Die Leuchtdiode 1 umfasst eine Anode 1a und eine Kathode 1b. Zu der Leuchtdiode 1 ist ein sogenannter Shunt-Widerstand 6 als Strommesswiderstand in Serie geschaltet. Die Stromüberwachungsschaltung 19 umfasst eine Referenzspannungsquelle 2, deren erster Ausgang 2a ein vorbestimmtes Referenzpotential U_{ref} zur Verfügung stellt und deren zweiter Ausgang 2b mit einem Massepotential M der Schaltungsanordnung 10 elektrisch verbunden ist. Der Wert des Referenzpotentials U_{ref} kann zum Beispiel einem Spannungswert einer elektrischen Spannung entsprechen, welche einem Spannungsabfall U_{RS} an dem Shunt-Widerstand 6 entspricht, wenn die Leuchtdiode 1 nicht defekt ist. Weiterhin umfasst die Stromüberwachungsschaltung 19 eine Komparatorschaltung 31, im Folgenden auch kurz Komparator genannt. Der Komparator 31 ist mit einem ersten Eingang 31a mit dem ersten Ausgang 2a der Referenzspannungsquelle 2 verbunden, so dass an seinem ersten Eingang 31a die Referenzspannung U_{ref} anliegt. Mit seinem zweiten Eingang 31b greift der Komparator 31 zwischen der Leuchtdiode 1 und dem Shunt-Widerstand 6 eine an dem Shunt-Widerstand 6 anliegende elektrische Spannung U_{RS} als Messsignal MS ab.

Am Ausgang 31c der Komparatorschaltung 31 kann ein Ausgangssignal AS1 zwischen zwei Signalwerten mit einem hohen Pegel (High-Signal bzw. H-Signal) und einem niedrigen Pegel (Low-Signal bzw. L-Signal) wechseln, je nachdem, ob an seinem ersten Eingang 31a oder an seinem zweiten Eingang 31b ein höheres Potential anliegt. In dem in FIG 1 gezeigten Ausführungsbeispiel ist der erste Eingang 31a des Komparators 31 als invertierender Eingang (mit "-" gekennzeichnet) ausgebildet und der zweite Eingang 31b des Komparators 31 als nicht-invertierender Eingang (mit "+" gekennzeichnet) ausgebildet.

Der Wert der Referenzspannung U_{ref} kann zum Beispiel so gewählt werden, dass er deutlich unter dem Wert der an dem Shunt-Widerstand 6 bei einer korrekt funktionierenden Leuchtdiode 1 abfallenden Spannung U_{RS} liegt. Somit liegt an dem zweiten Eingang 31b des Komparators 31 bei regulärem Betrieb ein höheres Potential an als an dem ersten Eingang 31a des Komparators 31. Mithin ergibt sich als Ausgangssignal ein Signal mit einem positiven Pegel (H-Signal), da am nicht-invertierenden Eingang 31b ein höheres Potential anliegt als an dem invertierenden Eingang 31a. Ereignet sich nun ein Defekt aufgrund eines Bruchs in der Leuchtdiode 1, mit dem ein starker Abfall des elektrischen Stroms durch die Leuchtdiode 1 verbunden ist, so fällt das an dem zweiten Eingang 31b des Komparators 31 anliegende Potential U_{RS} deutlich unter die an dem ersten Eingang anliegende Referenzspannung U_{ref} der Referenzspannungsquelle 2, so dass an dem Ausgang 31c des Komparators 31 ein Ausgangssignal AS1 mit einem niedrigen Potential (L-Signal) anliegt, da nun das an dem nicht-invertierenden Eingang 31b anliegende Potential niedriger ist als das an dem invertierenden Eingang 31a anliegende Potential. Eine solche Potentialänderung des Ausgangssignals AS1 des Komparators 31 kann als Hinweis auf das Auftreten eines Defekts der Leuchtdiode 1 aufgrund eines Bruchs in der Leuchtdiode 1 bzw. eines starken Abfalls des elektrischen Stroms I_{D} durch die Leuchtdiode 1 interpretiert werden. Da an einem der Eingänge des Komparators 31 ein Referenzpotential U_{ref} anliegt, arbeitet der Komparator 31 weitgehend ohne produktionsbedingte oder durch Temperaturänderungen verursachte Schwankungen. Auf diese Weise wird eine Messgenauigkeit erreicht, welche ausreichend ist, um die an einem Shunt-Widerstand abfallenden minimalen elektrischen Spannungen und die damit verbundenen elektrischen Ströme messen zu können.

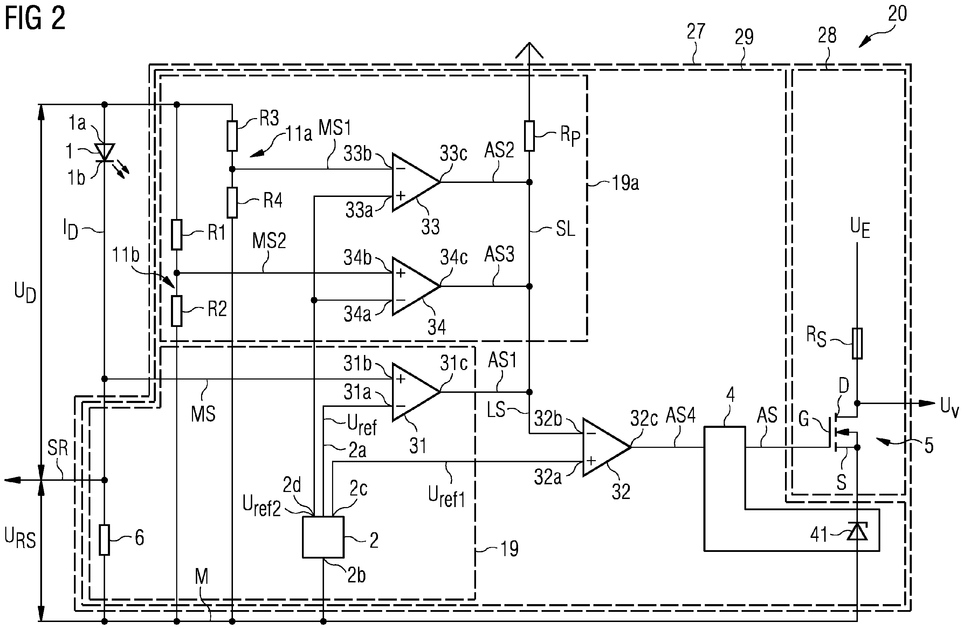

In FIG 2 ist ein Schaltbild gezeigt, welches eine Signalgeber-Schaltungsanordnung 20 mit einer Leuchtdiode 1 und einer Leuchtdioden-Steuerungsschaltung 27 umfasst. Die Leuchtdioden-Steuerungsschaltung 27 weist eine kombinierte Strom- und Spannungs-Überwachungsschaltung 29 auf. Teil der Leuchtdioden-Steuerungsschaltung 27 ist auch eine in FIG 2 gezeigte Sicherungsschaltung 28, welche dazu dient, für den Fall eines Defekts der Leuchtdiode 1, die Leuchtdiode 1 abzuschalten.

Die Strom-Spannungsüberwachungsschaltung 29 ist dazu eingerichtet zu ermitteln, ob der Wert der Stromstärke eines durch die Leuchtdiode 1 fließenden elektrischen Stroms I_{D} in einem vorbestimmten Werteintervall liegt, welches einer korrekt funktionierenden Leuchtdiode 1 zugeordnet ist. Wird ermittelt, dass der Wert der Stromstärke des durch die Leuchtdiode 1 fließenden elektrischen Stroms I_{D} einen vorbestimmten Referenzwert unterschreitet, so wird von der Strom-Spannungsüberwachungsschaltung 29 ein Steuerungssignal AS an die Sicherungsschaltung 28 ausgegeben, so dass eine in der Sicherungsschaltung 28 integrierte Sicherung die betreffende Leuchtdiode 1 von einer elektrischen Eingangsspannung U_{E} trennt und die Leuchtdiode 1 damit abschaltet. Zusätzlich ist die Strom-Spannungsüberwachungsschaltung 29 in der Lage, auch eine an der Leuchtdiode 1 abfallende elektrische Spannung U_{D} zu überwachen und für den Fall, dass die an der Leuchtdiode 1 abfallende elektrische Spannung U_{D} einen Wert annimmt, der außerhalb eines vorbestimmten Werteintervalls liegt, ebenfalls eine Abschaltung der Leuchtdiode 1 vorzunehmen. Die Strom-Spannungsüberwachungsschaltung 29 umfasst eine Stromüberwachungsschaltung 19 und eine Spannungsüberwachungsschaltung 19a. Die Stromüberwachungsschaltung 19 entspricht vom Aufbau her der in FIG 1 gezeigten Stromüberwachungsschaltung 19. Sie umfasst also einen Shunt-Widerstand 6, welcher mit der Leuchtdiode 1 in Reihe geschaltet ist. Zudem weist die Stromüberwachungsschaltung 19 auch eine Komparatorschaltung 31 auf. Weiterhin weist die Stromüberwachungsschaltung 19 eine Referenzspannungsquelle 2, deren zweiter Ausgang 2b mit einem Massepotential M der Schaltungsanordnung 20 elektrisch verbunden ist und deren erster, dritter und vierter Ausgang 2a, 2c, 2d ein vorbestimmtes Referenzpotential U_{ref}, U_{ref1}, U_{ref2} zur Verfügung stellen. Der Wert des ersten Referenzpotentials U_{ref} kann zum Beispiel einem Spannungswert einer elektrischen Spannung entsprechen, welche einem Spannungsabfall U_{RS} an dem Shunt-Widerstand 6 entspricht, wenn die Leuchtdiode 1 nicht defekt ist. Die dritte Referenzspannung U_{ref1} kann zum Beispiel den Wert einer elektrischen Spannung annehmen, die zwischen dem Spannungspegel eines H-Signals und eines L-Signals am Ausgang des Komparators 31 liegt. Der Wert der vierten Referenzspannung U_{ref2} kann zum Beispiel einem Spannungspegel U_{D} entsprechen, der an der Leuchtdiode 1 abfällt, wenn diese korrekt funktioniert.

Wie bereits erwähnt, umfasst die Stromüberwachungsschaltung 19 auch einen Komparator 31, welcher an seinem ersten Eingang 31a das genannte erste Referenzpotential U_{ref} des ersten Ausgangs 2a der Referenzspannungsquelle 2 erfasst und an seinem zweiten Eingang 31b eine an dem Shunt-Widerstand 6 abfallende elektrische Spannung U_{RS} misst. Der Komparator 31 führt eine Vergleichsoperation zwischen der gemessenen Spannung U_{RS} und der Referenzspannung U_{ref} des ersten Ausgangs 2a der Referenzspannungsquelle 2 durch. Ein dem Vergleichsergebnis entsprechendes Ausgangssignal AS1 liegt am Ausgang 31c des Komparators 31 der Stromüberwachungsschaltung 19 an. Dieses Ausgangssignal AS1 wird mit einem Ausgangssignal LS der Spannungsüberwachungsschaltung 19a zusammengeschaltet. In der in FIG 2 gezeigten Ausführungsform entspricht ein L-Signal am Ausgang der Stromüberwachungsschaltung 19 einem zu geringen Strom I_{D} der durch die Leuchtdiode 1 fließt. Liegt ein H-Signal am Ausgang der Stromüberwachungsschaltung an, was einer korrekten Funktion der Leuchtdiode 1 entspricht, so kann dieses H-Signal durch ein L-Signal von der Spannungsüberwachungsschaltung 19a immer noch überlagert und damit überdeckt werden. D.h., dass das Gesamtsignal LS durch ein Signal, welches einen Defekt anzeigt (ein L-Signal), bestimmt wird.

Die in FIG 2 gezeigte Spannungsüberwachungsschaltung 19a umfasst einen ersten Spannungsteiler 11a. Der erste Spannungsteiler 11a weist einen ersten ohmschen Widerstand R1 und einen zweiten ohmschen Widerstand R2 auf, die zueinander seriell geschaltet sind und parallel zu der Reihenschaltung aus Leuchtdiode 1 und Shunt-Widerstand 6 geschaltet sind. Zwischen dem ersten ohmschen Widerstand R1 und dem zweiten ohmschen Widerstand R2 liegt ein Abgriff für eine erste Komparatorschaltung 33 der Spannungsüberwachungsschaltung 19a, an dem ein erstes Messsignal MS1 erfasst wird, welches einen Spannungspegel umfasst, der zu der an der Leuchtdiode 1 abfallenden elektrischen Spannung U_{D} proportional ist. Die erste Komparatorschaltung 33 der Spannungsüberwachungsschaltung 19a ist mit ihrem ersten Eingang 33a, dem nichtinvertierenden Eingang (welcher mit "+" gekennzeichnet ist), mit dem vierten Ausgang 2d der Referenzspannungsquelle 2 elektrisch verbunden, so dass an dem nicht-invertierenden Eingang 33a eine von der Referenzspannungsquelle 2 definierte Referenzspannung U_{ref2} anliegt. Der zweite Eingang 33b, ein invertierender Eingang (mit "-" gekennzeichnet), der ersten Komparatorschaltung 33 bildet einen Abgriff des Komparators 33 zwischen dem ersten ohmschen Widerstand R1 und dem zweiten ohmschen Widerstand R2 des ersten Spannungsteilers 11a.

Ein zweiter Spannungsteiler 11b ist parallel zu dem ersten Spannungsteiler 11a und ebenfalls parallel zu der Reihenschaltung aus Leuchtdiode 1 und Shunt-Widerstand 6 geschaltet. Der zweite Spannungsteiler 11b weist einen dritten ohmschen Widerstand R3 und einen vierten ohmschen Widerstand R4 auf, die zueinander seriell geschaltet sind. Zwischen dem dritten ohmschen Widerstand R3 und dem vierten ohmschen Widerstand R4 liegt ein Abgriff für eine zweite Komparatorschaltung 34 der Spannungsüberwachungsschaltung 19a, an dem ein zweites Messsignal MS2 erfasst wird, welches einen Spannungspegel umfasst, der zu der an der Leuchtdiode 1 abfallenden elektrischen Spannung U_{D} proportional ist. Die zweite Komparatorschaltung 34 der Spannungsüberwachungsschaltung 19a ist mit ihrem ersten Eingang 34a, dem invertierenden Eingang 34a (welcher mit "-" gekennzeichnet ist), ebenfalls mit dem vierten Ausgang 2d der Referenzspannungsquelle 2 elektrisch verbunden, so dass an dem invertierenden Eingang 34a eine von der Referenzspannungsquelle 2 definierte Referenzspannung U_{ref2} anliegt. Der zweite Eingang 34b der zweiten Komparatorschaltung 34 der Spannungsüberwachungsschaltung 19a, ein nicht-invertierender Eingang (mit "+" gekennzeichnet), bildet einen Abgriff der zweiten Komparatorschaltung 34 der Spannungsüberwachungsschaltung 19a zwischen dem dritten ohmschen Widerstand R3 und dem vierten ohmschen Widerstand R4 des zweiten Spannungsteilers 11b.

Die beiden Ausgänge 33c, 34c der beiden Komparatoren 33, 34 der Spannungsüberwachungsschaltung 19a werden auf eine Signalleitung SL zusammengeführt. Das an der Signalleitung SL anliegende Signal wird für den Fall, dass an beiden Ausgängen 33c, 34c ein Signal mit einem hohen Pegel (H-Signal) anliegt, von einem sogenannten Pull-up-Widerstand Rₚ auf einen erhöhten Pegel gezogen. Die beiden Komparatoren 33, 34 der Spannungsüberwachungsschaltung 19a sind so verschaltet, dass für den Fall eines Defekts der Leuchtdiode 1 an einem Ausgang eines der beiden Komparatoren 33, 34 der Spannungsüberwachungsschaltung 19a ein Low-Signal (L-Signal), d.h. ein Signal mit einem niedrigen Pegel anliegt. Dies tritt immer dann ein, wenn an einem der invertierenden Eingänge 33b, 34a der beiden Komparatoren 33, 34 der Spannungsüberwachungsschaltung 19a ein Potential mit einem höheren Wert anliegt als an dem jeweiligen nicht-invertierenden Eingang 33a, 34b. Indem ein mit einem Defekt der Leuchtdiode 1 verbundenes Ausgangssignal AS2, AS3 der Komparatoren 33, 34 als L-Signal (Signal mit niedrigem Pegel) ausgebildet ist, kann eine zusätzliche ODER-Schaltung zur logischen Verknüpfung der an den beiden Ausgängen 33c, 34c der beiden Komparatoren 33, 34 der Spannungsüberwachungsschaltung 19a anliegenden logischen Signale eingespart werden. Denn bei der in FIG 2 gezeigten Konfiguration repräsentiert ein L-Signal einen starken Pegel, der sich gegenüber einem H-Signal durchsetzt, das als schwacher Pegel betrachtet werden kann, da der H-Pegel durch "Hochziehen" mit Hilfe des Pull-up-Widerstands Rₚ zustande kommt. Dagegen ist bei einem L-Signal am Ausgang 33c, 34c eines der beiden Komparatoren 33, 34 der Spannungsüberwachungsschaltung 19a der Ausgang auf Masse M oder ein anderes festes Bezugspotential geschaltet. Somit setzt sich ein L-Signal am Ausgang 33c, 34c eines der beiden Komparatoren 33, 34 der Spannungsüberwachungsschaltung 19a immer gegen ein H-Signal an dem Ausgang 33c, 34c des anderen Komparators 33, 34 der Spannungsüberwachungsschaltung 19a durch.

Die beiden Komparatoren 33, 34 der Spannungsüberwachungsschaltung 19a und auch der erste Komparator 31 der Stromüberwachungsschaltung 19 sind vorzugsweise mit einem sogenannten offenen Kollektor-Ausgang 31c, 33c, 34c (Open-Collector-Ausgang) ausgebildet. Die Ausbildung der Ausgänge 31c, 33c, 34c der Komparatoren 31, 33, 34 als offene Kollektorausgänge hat den Vorteil, dass die Ausgänge 31c, 33c, 34c der genannten Komparatoren 31, 33, 34 auf eine gemeinsame Signalleitung SL geschaltet werden können, ohne dass sich bei unterschiedlichem Ausgangspegel ein Kurzschlussstrom ausbildet, der die Schaltelemente der Komparatoren 31, 33, 34 beschädigen könnte. Somit können die Ausgänge 31c, 33c, 34c der Komparatoren 31, 33, 34 zueinander parallel geschaltet werden und ein andernfalls notwendiges zusätzliches ODER-Gatter kann eingespart werden.

Die Strom-Spannungsüberwachungsschaltung 29 umfasst auch einen zweiten Komparator 32, der als Negator funktioniert, d.h. ein an seinem invertierenden Eingang 32b anliegendes Signal invertiert. Ein erster Eingang 32a des zweiten Komparators 32, welcher ein nicht-invertierender Eingang (mit "+" gekennzeichnet) ist, ist mit einem dritten Ausgang 2c der Referenzspannungsquelle 2 verbunden, so dass an dem ersten Ausgang 32a des zweiten Komparators 32 eine von der Referenzspannungsquelle 2 definierte Referenzspannung U_{ref1} anliegt. Ein zweiter Eingang 32b des zweiten Komparators 32 ist an die Signalleitung SL angeschlossen, welche die drei Ausgangssignale AS, AS1, AS2 des ersten Komparators 31 der Strom-Spannungsüberwachungsschaltung 29 und des ersten Komparators 33 und des zweiten Komparators 34 der Spannungsüberwachungsschaltung 19 zusammenführt. Liegt nun an dem zweiten Eingang 32b der zweiten Komparatorschaltung 32 der Strom-Spannungsüberwachungsschaltung 29, welcher ein invertierender Eingang (mit "-" gekennzeichnet) ist, beispielsweise ein Signal mit einem H-Pegel, so wird dieses von dem zweiten Komparator 32 der Strom-Spannungsüberwachungsschaltung 29 invertiert, so dass am Ausgang 32c des zweiten Komparators 32 der Strom-Spannungsüberwachungsschaltung 29 ein Ausgangssignal AS4 mit einem L-Pegel anliegt. Ein Ausgangssignal AS4 mit einem L-Pegel entspricht der Information, dass die Leuchtdiode 1 korrekt funktioniert. Liegt dagegen an dem zweiten Eingang 32b des zweiten Komparators 32 der Strom-Spannungsüberwachungsschaltung 29 ein Signal mit einem L-Pegel an, so wird dieses Signal von dem zweiten Komparator 32 der Strom-Spannungsüberwachungsschaltung 29 in ein Signal mit einem H-Pegel invertiert, so dass an dem Ausgang 32c des zweiten Komparators 32 der Strom-Spannungsüberwachungsschaltung 29 ein Signal AS4 mit einem H-Pegel anliegt. Ein solches Signal entspricht der Information, dass die Leuchtdiode 1 einen Defekt aufweist. Die Strom-Spannungsüberwachungsschaltung 29 umfasst auch eine Signalanpassungsschaltung 4, welche mit dem Ausgang 32c des zweiten Komparators 32 der Strom-Spannungsüberwachungsschaltung 29 elektrisch verbunden ist und den Pegel des Ausgangssignals AS4 des zweiten Komparators 32 der Strom-Spannungsüberwachungsschaltung 29 an ein Spannungsniveau anpasst, welches mit einer erlaubten Eingangsspannung der an die Strom-Spannungsüberwachungsschaltung 29 angeschlossenen Sicherungsschaltung 28 kompatibel ist.

Bei der Spannungsüberwachung wird eine Überspannung (bei Bruch der LED) und eine Unterspannung (bei Kurzschluss der LED 1) überwacht. Bei der Stromüberwachung wird nur ein zu geringer Strom (und damit eine zu geringe Spannung am Strommesswiderstand 6) überwacht, da in diesem Fall die abgegebene Lichtstärke zu gering ist. Bei zu viel Strom leuchtet der Signalgeber 20 heller, was aber kein sicherheitstechnisches Problem darstellt. Wird der Strom im Fehlerfall so groß, dass die LED 1 überlastet wird, wird sie in den Zustand "Bruch" oder "Kurzschluss" übergehen. In einem solchen Fall wird der Defekt von der Spannungsüberwachung erkannt.

Das von der Signalanpassungsschaltung 4 ausgegebene endgültige Ausgangssignal AS wird an die Sicherungsschaltung 28 übermittelt. Die Sicherungsschaltung 28 umfasst einen Schalttransistor 5, in diesem Ausführungsbeispiel einen Feldeffekttransistor, genauer gesagt einen N-FET, dessen Gatter G mit dem Ausgang der Überwachungsschaltung 29 elektrisch verbunden ist. Die Quelle S (Source) des Schalttransistors 5 ist über die Signalanpassungsschaltung 4 und darin speziell über eine Z-Diode 41 mit dem Massepotential M verbunden und die Senke D (Drain) des Schalttransistors 5 ist mit einem Sicherungswiderstand Rₛ elektrisch verbunden, an dem wiederum eine Eingangsspannung U_{E} anliegt. Zwischen dem Sicherungswiderstand Rₛ und dem Schalttransistor 5 wird eine Versorgungsspannung Uᵥ abgegriffen, auf der über weitere hier nicht aufgeführte Schaltungselemente, wie zum Beispiel ein Schaltwandler, die Leuchtdiodenspannung U_{D} erzeugt wird.

Die Sicherungsschaltung 28 funktioniert wie folgt: Liegt an dem Eingang der Sicherungsschaltung 28 ein H-Signal an, was einem Schadensfall entspricht, so ist der Schalttransistor 5 leitend. Dies hat zur Folge, dass der Sicherungswiderstand R_{S} mit Masse M kurzgeschlossen ist und ein sehr starker Strom durch den Sicherungswiderstand R_{S} fließt, der den Sicherungswiderstand durchbrennen, d.h. unterbrechen lässt, so dass die Versorgungsspannung Uᵥ auf den Wert Null fällt. Damit liegt an der Ansteuerschaltung der Leuchtdiode 1 keine elektrische Spannung an, so dass die Leuchtdiode 1 ausgeschaltet ist. Liegt an dem Eingang der Sicherungsschaltung 28 ein L-Signal an, was einem regulären Betriebszustand entspricht, so sperrt der Schalttransistor 5. Dies hat zur Folge, dass der Sicherungswiderstand R_{S} von Masse M getrennt ist und eine Versorgungsspannung Uᵥ, welcher bei kleinem Sicherungswiderstand Rₛ der Eingangsspannung U_{E} entspricht, am Ausgang der Sicherungsschaltung 28 anliegt. Damit liegt an der Ansteuerschaltung der Leuchtdiode 1 eine von Null verschiedene elektrische Spannung U_{D} an und es wird eine von Null verschiedene elektrische Spannung U_{D} erzeugt, so dass die Leuchtdiode 1 eingeschaltet ist, was dem regulären Betrieb entspricht.

Indem zur Messung der Diodenspannung U_{D} Komparatoren statt Bipolartransistoren verwendet werden, kann die Genauigkeit der Messung der Diodenspannung U_{D} erheblich gesteigert werden. Bei gleichem Sicherheitsstandard führt dies im Vergleich zu herkömmlichen Schaltungen zu einer deutlich verbesserten Effektivität, da die Sicherheitstoleranzen deutlich geringer ausgelegt werden müssen, d.h. es werden viel weniger Dioden abgeschaltet, die eigentlich noch funktionieren. Anders betrachtet, wird bei gleicher Effektivität ein deutlich verbessertes Sicherheitsniveau erreicht, da die Wahrscheinlichkeit, dass defekte Leuchtdioden nicht erkannt werden, deutlich verringert wird.

An dem Shunt-Widerstand 6 der Schaltungsanordnung 20 in FIG 2 liegt auch ein Abgriff SR zur Ansteuerung einer Stromregulierung bei korrekter Funktion der Leuchtdiode an. Beispielsweise kann durch die Stromregulierung die Helligkeit der Leuchtdiode 1 je nach Helligkeit des Tageslichts variiert werden.

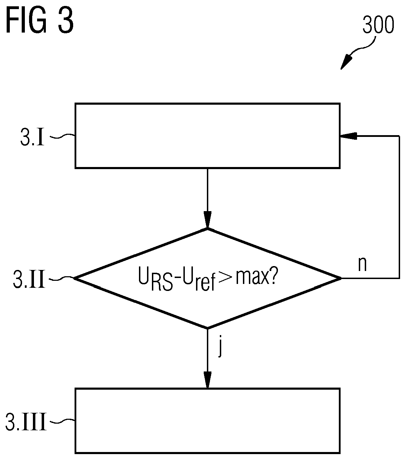

In FIG 3 ist ein Flussdiagramm 300 gezeigt, welches ein Verfahren zur Überwachung eines Leuchtdiodenstroms I_{D} eines Signalgebers veranschaulicht. Bei dem Schritt 3.I wird zunächst eine an einem zu einer Leuchtdiode seriell geschalteten Shunt-Widerstand abfallende elektrische Spannung U_{RS} gemessen. Bei dem Schritt 3.II erfolgt ein Vergleich des gemessenen elektrischen Spannungswerts U_{RS} mit einer Referenzspannung U_{ref}. Falls bei dem Vergleich ermittelt wird, dass die Differenz der beiden elektrischen Spannungen U_{RS}-U_{ref} einen Maximalwert max überschreitet, was in FIG 3 mit "j" gekennzeichnet wird, so wird bei dem Schritt 3.III ein Ausschaltsignal ausgegeben. Für den Fall, dass die Differenz der beiden elektrischen Spannungen U_{RS}-U_{ref} einen Maximalwert max nicht überschreitet, was in FIG 3 mit "n" gekennzeichnet ist, so wird zu dem Schritt 3.I zurückgegangen und die Überwachung der Leuchtdiode fortgesetzt. Der Vergleich bei dem Schritt 3.II kann sinngemäß auch mit der Prüfung der Differenz U_{RS}-U_{ref} < min oder der Differenz U_{ref}-U_{RS} > max bzw. U_{ref}-U_{RS} < min erfolgen.

Es wird abschließend noch einmal darauf hingewiesen, dass es sich bei den vorbeschriebenen Verfahren und Vorrichtungen lediglich um bevorzugte Ausführungsbeispiele der Erfindung handelt und dass die Erfindung vom Fachmann variiert werden kann, ohne den Bereich der Erfindung zu verlassen, soweit er durch die Ansprüche vorgegeben ist. Die Erfindung ist insbesondere nicht auf die Überwachung einer einzelnen Leuchtdiode mit Hilfe einer Stromüberwachungsschaltung oder einer Strom-Spannungsüberwachungsschaltung beschränkt. Üblicherweise sind in Signalgebern Gruppen von drei zueinander seriell geschalteten Leuchtdioden installiert. Wenn also vorstehend von einer Leuchtdiode gesprochen wurde, kann diese auch eine Serienschaltung von mehreren Leuchtdioden umfassen. Es wird der Vollständigkeit halber auch darauf hingewiesen, dass die Verwendung der unbestimmten Artikel "ein" bzw. "eine" nicht ausschließt, dass die betreffenden Merkmale auch mehrfach vorhanden sein können. Ebenso schließt der Begriff "Einheit" nicht aus, dass diese aus mehreren Komponenten besteht, die gegebenenfalls auch räumlich verteilt sein können.

## Patentansprüche

1. Leuchtdioden-Steuerungsschaltung (27), aufweisend:
- eine Stromüberwachungsschaltung (19) für eine Leuchtdiodenanordnung (1) eines Signalgebers einer Lichtsignalanlage, umfassend:
- eine Referenzspannungsquelle (2) mit einem Eingang und mindestens einem ersten Ausgang (2a) und einem zweiten Ausgang (2b),
- eine Komparatorschaltung (31) mit einem ersten Eingang (31a), einem zweiten Eingang (31b) und einem Signalausgang (31c),
- einen Messwiderstand (6), der zu der Leuchtdiodenanordnung (1) in Serie geschaltet ist,
wobei
- der erste Ausgang (2a) der Referenzspannungsquelle (2) ein durch die Referenzspannungsquelle (2) definiertes Referenzpotential (U_{ref}) aufweist und mit dem ersten Eingang (31a) der Komparatorschaltung (31) elektrisch verbunden ist und
- der Messwiderstand (6) zwischen den zweiten Ausgang (2b) der Referenzspannungsquelle (2) und den zweiten Eingang (31b) der Komparatorschaltung (31) geschaltet ist,
- eine Leuchtdiodenschnittstelle,
- eine Sicherungsschaltung (28), welche mit dem Signalausgang (31c) der Stromüberwachungsschaltung (19) elektrisch verbunden ist, wobei die Sicherungsschaltung (28) durch ein Ausschaltsignal an dem Signalausgang (31c) der Stromüberwachungsschaltung (19) in einen Ausschaltzustand versetzbar ist
- eine Spannungsüberwachungsschaltung (19a) zur Überwachung der an der Leuchtdiodenanordnung (1) abfallenden elektrischen Spannung (U_{D}),
**gekennzeichnet durch**
eine zweite Komparatorschaltung (32) mit einem ersten nicht-invertierenden Eingang (32a), einem zweiten invertierenden Eingang (32b) und einem Ausgang (32c), wobei der erste Eingang (32a) der zweiten Komparatorschaltung (32) mit einem dritten Ausgang (2c) der Referenzspannungsquelle (2) elektrisch verbunden ist und der zweite Eingang (32b) der zweiten Komparatorschaltung (32) mit einem Ausgang der Spannungsüberwachungsschaltung (19a) und dem Signalausgang (31c) der Stromüberwachungsschaltung (19) elektrisch verbunden ist.

2. Leuchtdioden-Steuerungsschaltung (27) nach Anspruch 1, wobei der zweite Ausgang (2b) der Referenzspannungsquelle (2) mit einem festen zweiten Referenzpotential (M) elektrisch verbunden ist.

3. Leuchtdioden-Steuerungsschaltung (27) nach Anspruch 1 oder 2, wobei die Spannungsüberwachungsschaltung (19a) aufweist:
- eine dritte Komparatorschaltung (33) mit einem ersten Eingang (33a), einem zweiten Eingang (33b) und einem Signalausgang (33c),
wobei
- der erste Eingang (33a) mit einem vierten Ausgang (2d) der Referenzspannungsquelle (2) elektrisch verbunden ist, an dem ein durch die Referenzspannungsquelle (2) definiertes viertes Referenzpotential (U_{ref2}) anliegt, und
- der zweite Eingang (33b) der dritten Komparatorschaltung (33) mit einem Anschluss (1a) der Leuchtdiodenanordnung (1) des Signalgebers elektrisch verbunden ist.

4. Leuchtdioden-Steuerungsschaltung (27) nach einem der vorstehenden Ansprüche, aufweisend einen ersten Spannungsteiler (11a), welcher parallel zu der Leuchtdiodenanordnung (1) geschaltet ist und einen ersten ohmschen Widerstand (R1) und einen zweiten ohmschen Widerstand (R2) aufweist, welche zueinander in Reihe geschaltet sind, wobei der zweite Eingang (33b) der dritten Komparatorschaltung (33) zwischen den ersten ohmschen Widerstand (R1) und den zweiten ohmschen Widerstand (R2) geschaltet ist.

5. Leuchtdioden-Steuerungsschaltung (27) nach einem der vorstehenden Ansprüche, aufweisend eine vierte Komparatorschaltung (34) mit einem ersten Eingang (34a), einem zweiten Eingang (34b) und einem Signalausgang (34c), wobei der erste Eingang (34a) der vierten Komparatorschaltung (34b) mit dem ersten Eingang (34a) der dritten Komparatorschaltung (33) parallel geschaltet ist und wobei der zweite Eingang (34b) der vierten Komparatorschaltung (34) mit dem ersten Anschluss (1a) der Leuchtdiodenanordnung (1) elektrisch verbunden ist.

6. Leuchtdioden-Steuerungsschaltung (27) nach Anspruch 5, wobei der erste Eingang (33a) der dritten Komparatorschaltung (33) ein nicht-invertierender Eingang ist, der zweite Eingang (33b) der dritten Komparatorschaltung (33) ein invertierender Eingang ist, der erste Eingang (34a) der vierten Komparatorschaltung (34) ein invertierender Eingang ist und der zweite Eingang (34b) der vierten Komparatorschaltung (34) ein nicht-invertierender Eingang ist.

7. Leuchtdioden-Steuerungsschaltung (27) nach einem der Ansprüche 5 oder 6, aufweisend einen zweiten Spannungsteiler (11b), welcher parallel zu dem ersten Spannungsteiler (11a) geschaltet ist und einen dritten ohmschen Widerstand (R3) und einen vierten ohmschen Widerstand (R4) umfasst, welche zueinander in Serie geschaltet sind, wobei der zweite Eingang (34b) der vierten Komparatorschaltung (34) zwischen den dritten ohmschen Widerstand (R3) und den vierten ohmschen Widerstand (R4) des zweiten Spannungsteilers (11b) geschaltet ist.

8. Leuchtdioden-Steuerungsschaltung (27) nach einem der Ansprüche 5 bis 7, wobei die Ausgänge (33c, 34c) der dritten und vierten Komparatorschaltung (33, 34) der Spannungsüberwachungsschaltung (19a) mit dem zweiten Eingang (32b) der zweiten Komparatorschaltung (32) elektrisch verbunden sind und/ oder die Ausgänge (31c, 33c, 34c) der ersten, dritten und vierten Komparatorschaltung (31, 33, 34) als offene Kollektor-Ausgänge ausgebildet sind und/oder die Ausgänge (31c, 33c, 34c) der ersten, dritten und vierten Komparatorschaltung (31, 33, 34) mit einem Pull-up-Widerstand (R_{P}) elektrisch verbunden sind.

9. Leuchtdioden-Steuerungsschaltung (27) nach einem der Ansprüche 1 bis 8, ferner aufweisend eine Spannungsüberwachungsschaltung (19a) zur Überwachung der an der Leuchtdiodenanordnung (1) abfallenden elektrischen Spannung (U_{D}).

10. Leuchtdioden-Steuerungsschaltung (27) nach einem der Ansprüche 1 bis 9, wobei die Sicherungsschaltung (28) einen Transistor, vorzugsweise einen Feldeffekttransistor (5), und einen mit dem Transistor (5) in Reihe geschalteten Sicherungswiderstand (R_{S}) umfasst, wobei vorzugsweise das Gatter (G) des Transistors (5) mit dem Ausgang (32c) der zweiten Komparatorschaltung elektrisch verbunden ist.

11. Signalgeber (10, 20) für eine Lichtsignalanlage, aufweisend:
- eine Leuchtdiodenanordnung (1),
- eine Leuchtdioden-Steuerungsschaltung (27) nach einem der Ansprüche 1 bis 10.

12. Verwendung einer Leuchtdioden-Steuerungsschaltung (27) nach einem der Ansprüche 1 bis 10 zur Überwachung der Funktion einer Leuchtdiodenanordnung (1) eines Signalgebers einer Lichtsignalanlage.

## Claims

1. Light-emitting diode control circuit (27), having:
- a current monitoring circuit (19) for a light-emitting diode arrangement (1) for a signal generator of an illuminating signal system, comprising:
- a reference voltage source (2) having an input and at least a first output (2a) and a second output (2b),
- a comparator circuit (31) having a first input (31a), a second input (31b) and a signal output (31c),
- a measuring resistor (6) which is connected in series to the light-emitting diode arrangement (1),
wherein
- the first output (2a) of the reference voltage source (2) has a reference potential (U_{ref}) defined by the reference voltage source (2) and is electrically connected to the first input (31a) of the comparator circuit (31) and
- the measuring resistor (6) is connected between the second output (2b) of the reference voltage source (2) and the second input (31b) of the comparator circuit (31),
- a light-emitting diode interface,
- a fuse circuit (28) which is electrically connected to the signal output (31c) of the current monitoring circuit (19), wherein the fuse circuit (28) can be set to an off state by a switch-off signal at the signal output (31c) of the current monitoring circuit (19),
- a voltage monitoring circuit (19a) for monitoring the electrical voltage (U_{D}) drop at the light-emitting diode arrangement (1),
**characterised by**
a second comparator circuit (32) having a first non-inverting input (32a), a second inverting input (32b) and an output (32c), wherein the first input (32a) of the second comparator circuit (32) is electrically connected to a third output (2c) of the reference voltage source (2) and the second input (32b) of the second comparator circuit (32) is electrically connected to an output of the voltage monitoring circuit (19a) and the signal output (31c) of the current monitoring circuit (19) .

2. Light-emitting diode control circuit (27) according to claim 1, wherein the second output (2b) of the reference voltage source (2) is electrically connected to a fixed second reference potential (M).

3. Light-emitting diode control circuit (27) according to claim 1 or 2, wherein the voltage monitoring circuit (19a) has:
- a third comparator circuit (33) having a first input (33a), a second input (33b) and a signal output (33c),
wherein
- the first input (33a) is electrically connected to a fourth output (2d) of the reference voltage source (2), to which a fourth reference potential (U_{ref2}) defined by the reference voltage source (2) is applied, and
- the second input (33b) of the third comparator circuit (33) is electrically connected to a terminal (1a) of the light-emitting diode arrangement (1) of the signal generator.

4. Light-emitting diode control circuit (27) according to one of the preceding claims, having a first voltage divider (11a), which is connected in parallel to the light-emitting diode arrangement (1), and a first ohmic resistor (R1) and a second ohmic resistor (R2) which are connected to each other in series, wherein the second input (33b) of the third comparator circuit (33) is connected between the first ohmic resistor (R1) and the second ohmic resistor (R2).

5. Light-emitting diode control circuit (27) according to one of the preceding claims, having a fourth comparator circuit (34) with a first input (34a), a second input (34b) and a signal output (34c), wherein the first input (34a) of the fourth comparator circuit (34b) is connected in parallel to the first input (34a) of the third comparator circuit (33) and wherein the second input (34b) of the fourth comparator circuit (34) is electrically connected to the first terminal (1a) of the light-emitting diode arrangement (1).

6. Light-emitting diode control circuit (27) according to claim 5, wherein the first input (33a) of the third comparator circuit (33) is a non-inverting input, the second input (33b) of the third comparator circuit (33) is an inverting input, the first input (34a) of the fourth comparator circuit (34) is an inverting input and the second input (34b) of the fourth comparator circuit (34) is a non-inverting input.

7. Light-emitting diode control circuit (27) according to one of claims 5 or 6, having a second voltage divider (11b) which is connected in parallel to the first voltage divider (11a) and comprises a third ohmic resistor (R3) and a fourth ohmic resistor (R4) which are connected to each other in series, wherein the second input (34b) of the fourth comparator circuit (34) is connected between the third ohmic resistor (R3) and the fourth ohmic resistor (R4) of the second voltage divider (11b).

8. Light-emitting diode control circuit (27) according to one of claims 5 to 7, wherein the outputs (33c, 34c) of the third and fourth comparator circuit (33, 34) of the voltage monitoring circuit (19a) are electrically connected to the second input (32b) of the second comparator circuit (32) and/or the outputs (31c, 33c, 34c) of the first, third and fourth comparator circuit (31, 33, 34) are designed as open collector outputs and/or the outputs (31c, 33c, 34c) of the first, third and fourth comparator circuit (31, 33, 34) are electrically connected to a pull-up resistor (R_{P}).

9. Light-emitting diode control circuit (27) according to one of claims 1 to 8, further having a voltage monitoring circuit (19a) for monitoring the electrical voltage (U_{D}) drop at the light-emitting diode arrangement (1).

10. Light-emitting diode control circuit (27) according to one of claims 1 to 9, wherein the fuse circuit (28) comprises a transistor, preferably a field effect transistor (5), and a fuse resistor (R_{S}) connected to the transistor (5) in series, wherein preferably the gate (G) of the transistor (5) is electrically connected to the output (32c) of the second comparator circuit.

11. Signal generator (10, 20) for an illuminating signal system, having:
- a light-emitting diode arrangement (1),
- a light-emitting diode control circuit (27) according to one of claims 1 to 10.

12. Use of a light-emitting diode control circuit (27) according to one of claims 1 to 10 for monitoring the function of a light-emitting diode arrangement (1) of a signal generator of an illuminating signal system.

## Revendications

1. Circuit (27) de commande de diodes électroluminescentes, comportant :
- un circuit (19) du contrôle du courant pour un système (1) à diodes électroluminescentes d'un capteur de signal d'une installation à signal lumineux, comprenant :
- une source (2) de tension de référence, ayant une entrée et au moins une première sortie (2a) et une deuxième sortie (2b),
- un circuit (31) de comparateur, ayant une première entrée (31a), une deuxième entrée (31b) et une sortie (31c) de signal,
- une résistance (6) de mesure, montée en série avec le système (1) de diodes électroluminescentes,
dans lequel
- la première sortie (2a) de la source (2) de tension de référence a un potentiel (U_{ref}) de référence défini par la source (2) de tension de référence et est reliée électriquement à la première entrée (31a) du circuit (31) de comparateur et
- la résistance (6) de mesure est montée entre la deuxième sortie (2b) de la source (2) de tension de référence et la deuxième entrée (31b) du circuit (31) de comparateur,
- une interface de diodes électroluminescentes,
- un circuit (28) de sécurité, qui est relié électriquement à la sortie (31c) du signal du circuit (19) de contrôle du courant, le circuit (28) de sécurité pouvant être mis dans un état de déconnexion par un signal de déconnexion à la sortie (31c) du signal du circuit (19) de contrôle du courant
- un circuit (19a) de contrôle de la tension pour contrôler la tension (U_{D}) électrique chutant aux bornes du système (1) de diodes électroluminescentes,
**caractérisé par**
un deuxième circuit (32) de comparateur, ayant une première entrée (32a) non inverseuse, un deuxième entrée (32b) inverseuse et une sortie (32c), la première entrée (32a) du deuxième circuit (32) de comparateur étant reliée électriquement à une troisième sortie (2c) de la source (2) de tension de référence et la deuxième entrée (32b) du deuxième circuit (32) de comparateur étant reliée électriquement à une sortie du circuit (19a) du contrôle de la tension et à la sortie (31c) du signal du circuit (19) du contrôle du courant.

2. Circuit (27) de commande de diodes électroluminescentes suivant la revendication 1, dans lequel la deuxième sortie (2b) de la source (2) de tension de référence est reliée électriquement à un deuxième potentiel (M) de référence fixe.

3. Circuit (27) de commande de diodes électroluminescentes suivant la revendication 1 ou 2, dans lequel le circuit (19a) de contrôle de la tension a :
- un troisième circuit (33) de comparateur, ayant une première entrée (33a), une deuxième entrée (33b) et une sortie (33c) du signal,
dans lequel
- la première entrée (33a) est reliée électriquement à une quatrième sortie (2d) de la source (2) de tension de référence où s'applique un quatrième potentiel (U_{ref2}) de référence, défini par la source (2) de tension de référence et
- la deuxième entrée (33b) du troisième circuit (33) de comparateur est reliée électriquement à une borne (1a) du système (1) de diodes électroluminescentes du capteur de signal.

4. Circuit (27) de commande de diodes électroluminescentes suivant l'une des revendications précédentes, comprenant un premier diviseur (11a) de tension, qui est monté en parallèle avec le système (1) de diodes électroluminescentes et qui a une première résistance (R1) ohmique et une deuxième résistance (R2) ohmique, qui sont montées en série l'une avec l'autre, la deuxième entrée (33b) du troisième circuit (33) de comparateur étant montée entre la première résistance (R1) ohmique et la deuxième résistance (R2) ohmique.

5. Circuit (27) de commande de diodes électroluminescentes suivant l'une des revendications précédentes, comportant un quatrième circuit (34) de comparateur, ayant une première entrée (34a), une deuxième entrée (34b) et une sortie (34c) du signal, la première entrée (34a) du quatrième circuit (34b) de comparateur étant montée en parallèle avec la première entrée (34a) du troisième circuit (33) comparateur et la deuxième entrée (34b) du quatrième circuit (34) de comparateur étant reliée électriquement à la première borne (1a) du système (1) de diodes électroluminescentes.

6. Circuit (27) de commande de diodes électroluminescentes suivant la revendication 5, dans lequel la première entrée (33a) du troisième circuit (33) de comparateur est une entrée non inverseuse, la deuxième entrée (33b) du troisième circuit (33) de comparateur est une entrée inverseuse, la première entrée (34a) du quatrième circuit (34) de comparateur est une entrée inverseuse et la deuxième entrée (34b) du quatrième circuit (34) de comparateur est une entrée non inverseuse.

7. Circuit (27) de commande de diodes électroluminescentes suivant l'une des revendications 5 ou 6, comportant un deuxième diviseur (11b) de tension, qui est monté en parallèle avec le premier diviseur (11a) de tension et qui comprend une troisième résistance (R3) ohmique et une quatrième résistance (R4) ohmique, qui sont montées en série l'une avec l'autre, la deuxième entrée (34b) du quatrième circuit (34) de comparateur étant montée entre la troisième résistance (R3) ohmique et la quatrième résistance (R4) ohmique du deuxième diviseur (11b) de tension.

8. Circuit (27) de commande de diodes électroluminescentes suivant l'une des revendications 5 à 7, dans lequel les sorties (33c, 34c) des troisième et quatrièmes circuits (33, 34) de comparateur du circuit (19a) de contrôle de la tension sont reliées électriquement à la deuxième entrée (32b) du deuxième circuit (32) de comparateur et/ou les sorties (31c, 33c, 34c) des premier, troisième et quatrième circuits (31, 33, 34) de comparateur sont constituées sous la forme de sorties de collecteur ouvertes et/ou les sorties (31c, 33c, 34c) des premier, troisième et quatrième circuits (31, 33, 34) de comparateur sont reliées à une résistance (R_{P}) pull-up.

9. Circuit (27) de commande de diodes électroluminescentes suivant l'une des revendications 1 à 8, comportant, en outre, un circuit (19a) de contrôle de la tension pour contrôler la tension (U_{D}) électrique chutant aux bornes du système (1) de diodes électroluminescentes.

10. Circuit (27) de commande de diodes électroluminescentes suivant l'une des revendication 1 à 9, dans lequel le circuit (28) de sécurité comprend un transistor, de préférence un transistor (5) à effet de champ, et une résistance (R_{S}) de sécurité montée en série avec le transistor (5), la grille (G) du transistor (5) étant, de préférence, reliée électriquement à la sortie (32c) du deuxième circuit de comparateur.

11. Capteur (10, 20) de signal pour une installation à signal lumineux,
comportant :
- un système (1) de diodes électroluminescentes,
- un circuit (27) de commande de diodes électroluminescentes suivant l'une des revendications 1 à 10.

12. Utilisation d'un circuit (27) de commande de diodes électroluminescentes suivant l'une des revendications 1 à 10, pour contrôler le fonctionnement d'un système (1) de diodes électroluminescentes d'un capteur de signal d'une installation à signal lumineux.
